# DEMANDE DE BREVET EUROPEEN

(11) **EP 4 815 710 A1**
(43) Date de publication de la demande: **30.09.2026**
(21) Numéro de dépôt: 26166613.5
(22) Date de dépôt: 23.03.2026
(51) Int. Cl.: H10W 40/10, H10W 40/70, H10W 74/10, H10W 76/40

(54) **BOITIER DE CIRCUIT INTEGRE**

(30) Priorité: 27.03.2025 FR 2503140
(71) Demandeur: STMicroelectronics International N.V., 1228 Plan-les-Ouates, Geneva (CH)
(72) Inventeur: HAJJI, Asma, 38500 Voiron (FR); HAJJI, Ouafa, 38500 Voiron (FR); QUERCIA, Fabien, 38160 Saint Marcellin (FR); BOUTALEB, Younes, 38000 Grenoble (FR)
(74) Mandataire: Cabinet Beaumont

(57) **Abrégé**

La présente description concerne un procédé de fabrication d'un dispositif électronique (1000) comprenant les étapes suivantes :
a) fournir un ensemble comprenant une puce (100) et un substrat d'interconnexion (200), la puce ayant une première face (101) comprenant des plages de connexion (120) et une deuxième face (102), les plages de connexion (120) étant assemblée sur le substrat d'interconnexion (200) par des plots de contact (110), la puce (100) étant moulée dans un composé de moulage (400), par exemple un composé de moulage époxy, la deuxième face (102) de la puce (100) étant accessible,
b) assembler un capot (300) sur l'ensemble fourni à l'étape a), un espace étant formé entre le capot (300) et la deuxième face (102) de la puce (100),
c) injecter une résine thermiquement conductrice (500) de manière à remplir l'espace entre le capot (300) et la deuxième face (102) de la puce (100), la résine thermiquement conductrice étant une résine dans laquelle sont dispersées des charges thermiquement conductrices.

## Description

### Domaine technique

La présente description concerne de façon générale les composants électroniques et, plus particulièrement, les boîtiers de circuit intégré, par exemple les boîtiers de type matrice de billes (ou BGA pour "Ball Grid Array") et le montage de puces électroniques dans ces boîtiers.

### Technique antérieure

Les boîtiers de type BGA permettent d'intégrer électriquement une puce électronique à un élément extérieur comme, par exemple à un circuit imprimé (ou PCB pour "Printed Circuit Board").

Avec la miniaturisation des composants électroniques, la gestion de la dissipation thermique devient de plus en plus critique. Pour améliorer les performances thermiques des composants électroniques, les boîtiers comprennent un capot (ou couvercle) thermiquement conducteur positionné au-dessus de la puce. Le capot permet de participer à la dissipation de la chaleur produite par la puce.

La présence d'un matériau d'interface thermique (ou TIM pour 'Thermal Interface Material') positionné sur la puce et en contact avec le capot peut faciliter la dissipation thermique.

Le capot, lorsqu'il a une forme de chapeau ('hat like lid') peut être fixé directement sur le substrat au moyen d'une colle. La dissipation de la chaleur se fait par la face arrière de la puce *via* la couche de TIM.

Il existe également des boîtiers de type BGA pour lesquels la puce, assemblée au substrat, est enrobée dans un composé de moulage laissant accessible la face arrière de la puce. Le matériau d'interface thermique (TIM) est ensuite appliqué sur la face arrière de la puce et sur une partie de l'EMC. Le capot plan est ensuite monté sur le TIM.

Le TIM jouant à la fois le rôle de dissipateur thermique et d'adhésif, il présente généralement une conductivité thermique de 2W/m.K au plus.

### Résumé de l'invention

Il existe un besoin d'amélioration des boîtiers pour puces électroniques, et notamment un besoin d'améliorer la dissipation thermique de ces boîtiers.

Ce but est atteint par un procédé de fabrication d'un dispositif électronique comprenant les étapes suivantes :
a) fournir un ensemble comprenant une puce et un substrat d'interconnexion, la puce ayant une première face recouverte par des plages de connexion et une deuxième face, les plages de connexion étant assemblée sur le substrat d'interconnexion par des plots de contact, la puce étant moulée dans un composé de moulage, par exemple un composé de moulage époxy, laissant accessible la deuxième face de la puce,
b) assembler un capot sur l'ensemble fourni à l'étape a), un espace étant formé entre le capot et la deuxième face de la puce,
c) injecter une résine thermiquement conductrice de manière à remplir l'espace entre le capot et la deuxième face de la puce.

Selon un mode de réalisation particulier, la résine thermiquement conductrice est une résine époxy dans laquelle sont dispersées des charges thermiquement conductrices, par exemple des charges en silice.

Selon un mode de réalisation particulier, la résine thermiquement conductrice et le composé de moulage sont en un même matériau.

Selon un mode de réalisation particulier, le capot est une plaque et le capot est collé sur le composé de moulage, au moyen de points de colle ou d'un cordon discontinu de colle.

Selon un mode de réalisation particulier, le capot comprend une partie plane et des éléments faisant saillie à partir de la partie plane, les éléments faisant saillie étant fixés au fond de cavités formées dans le composé de moulage.

Selon un mode de réalisation particulier, les cavités ont une épaisseur inférieure à l'épaisseur du composé de moulage et les éléments faisant saillie sont collés sur le composé de moulage formant le fond des cavités.

Selon un mode de réalisation particulier, les cavités débouchent sur le substrat d'interconnexion et les éléments faisant saillie sont collés ou brasés sur le substrat d'interconnexion.

Selon un mode de réalisation particulier, les éléments faisant saillie forment des pieds, par exemple quatre pieds, ou des plaques.

Selon un mode de réalisation particulier, l'étape c) est réalisée par moulage assisté par film.

Ce but est également atteint par un dispositif électronique comprenant une puce électronique disposée entre un substrat d'interconnexion et un capot, la puce ayant une première face recouverte par des plages de connexion et une deuxième face, les plages de connexion étant assemblée sur le substrat d'interconnexion par des plots de contact,
la puce étant moulée dans un composé de moulage, par exemple un composé de moulage époxy, laissant accessible la deuxième face de la puce,
un capot, de préférence en cuivre, recouvrant la deuxième face de la puce,
une résine thermiquement conductrice remplissant l'espace entre le capot et la deuxième face de la puce et, de préférence recouvrant les flancs du capot.

Selon un mode de réalisation particulier, la résine thermiquement conductrice est une résine époxy dans laquelle sont dispersées des charges thermiquement conductrices.

Selon un mode de réalisation particulier, la résine thermiquement conductrice est identique au composé de moulage.

Selon un mode de réalisation particulier, le capot est une plaque et le capot est collé sur le composé de moulage, au moyen de points de colle ou d'un cordon discontinu de colle.

Selon un mode de réalisation particulier, le capot comprend une partie plane et des éléments faisant saillie à partir de la partie plane, les éléments faisant saillie étant fixés au fond de cavités formées dans le composé de moulage.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B et la figure 1C représentent, de manière schématique différentes étapes d'un procédé de fabrication d'un boîtier de circuits intégrés, selon un mode de réalisation particulier ;
la figure 2A, la figure 2B et la figure 2C représentent, de manière schématique différentes étapes d'un procédé de fabrication d'un boîtier de circuits intégrés, selon un autre mode de réalisation particulier ;
la figure 3A, la figure 3B et la figure 3C représentent, de manière schématique différentes étapes d'un procédé de fabrication d'un boîtier de circuits intégrés, selon un autre mode de réalisation particulier ;
la figure 4A, la figure 4B et la figure 4C représentent, de manière schématique et en trois dimensions, différents capots pour boîtier de circuits intégrés selon différents modes de réalisation particulier de l'invention ;
la figure 5A, la figure 5B et la figure 5C représentent, de manière schématique et en vue de dessus, une puce enrobée dans un composé de moulage sur lequel de la colle a été déposée, selon différents modes de réalisation de l'invention.

Dans les différentes figures, les différents éléments et composants ne sont pas nécessairement représentés à la même échelle les uns par rapport aux autres.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Par compris entre X et Y, on entend que les bornes X et Y sont incluses, ce qui est équivalent à au moins X et jusqu'à Y.

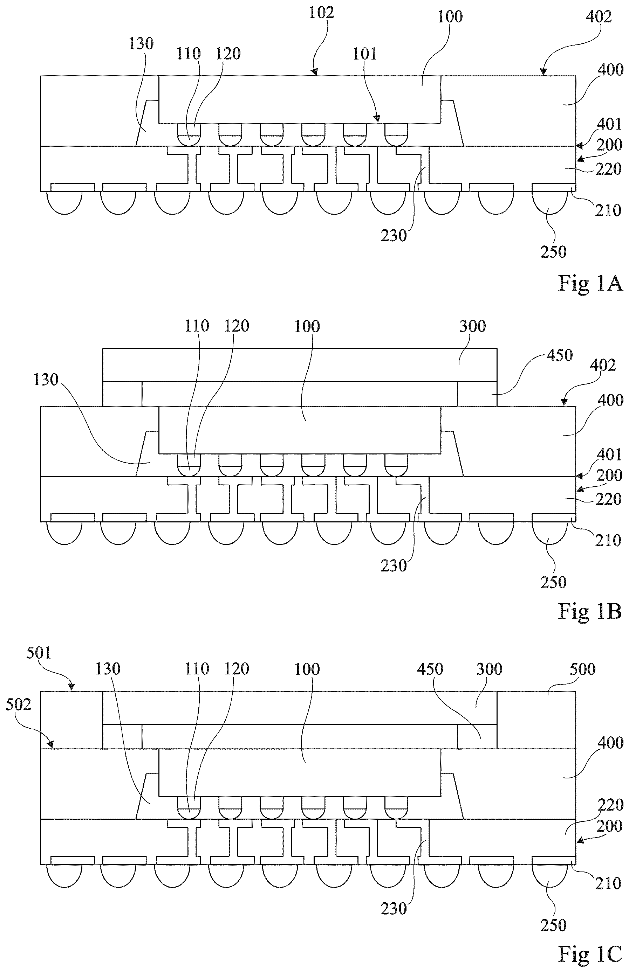

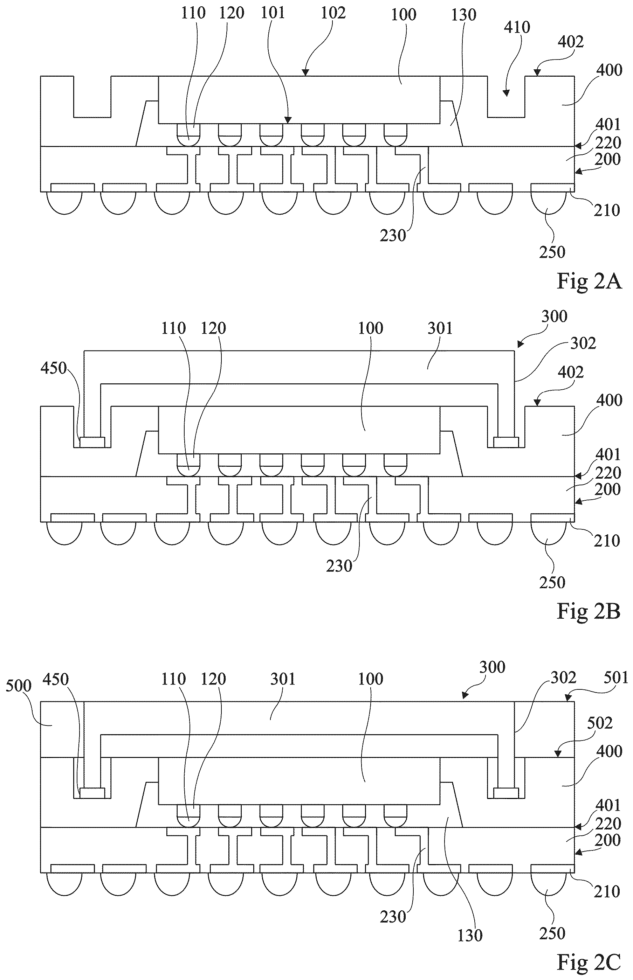

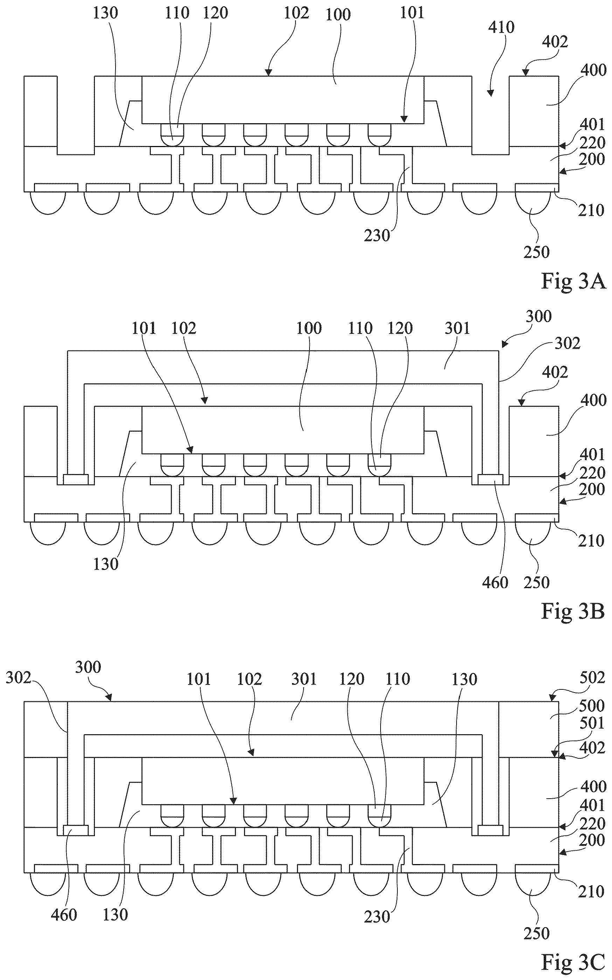

Nous allons maintenant décrire le procédé de fabrication d'un boîtier pour circuits intégrés en faisant référence aux figures 1A à 1C, aux figures 2A à 2C et aux figures 3A à 3C.

Le procédé comprend les étapes suivantes :
a) fournir un ensemble comprenant une puce 100, ayant une première face 101 et une deuxième face 102, et un substrat d'interconnexion 200,
   la puce la première face 101 de la puce 100 comprenant des plages d'interconnexion 120,
   les plages d'interconnexion 120 étant assemblées sur le substrat d'interconnexion 200 par des plots de contact 110, la puce 100 étant enrobée dans un composé de moulage 400, par exemple un composé de moulage époxy, laissant accessible la deuxième face 102 de la puce 100 (figures 1A, 2A et 3A),
b) assembler un capot 300 sur l'ensemble fourni à l'étape a), par exemple en le collant sur le composé de moulage 400 ou en le collant ou le brasant sur le substrat d'interconnexion 200, le capot 300 recouvrant la puce 100, un espace étant formé entre le capot 300 et la deuxième face 102 de la puce 100 (figures 1B, 2B et 3B),
c) injecter une résine thermiquement conductrice 500 de manière à remplir l'espace entre le capot 300 et la deuxième face 102 de la puce 100, et de préférence, à recouvrir les flancs du capot 300, la résine thermiquement conductrice 500 étant en contact avec le capot 300 et avec la deuxième face 102 de la puce 100 (figures 1C, 2C et 3C).

La résine thermiquement conductrice est un matériau de sous-remplissage moulé (ou MUF pour 'molded underfill'). Par résine thermiquement conductrice, on entend un matériau composite comprenant une résine (de préférence une résine époxy) et des charges thermiquement conductrices. Les charges thermiquement conductrices sont, par exemple, des charges inorganiques. Il peut s'agir de silice, de nitrure d'aluminium, d'oxyde de zinc, de carbure de bore, de nitrure de bore hexagonal (h-BN) ou de nitrure d'aluminium. La conductivité thermique de la résine thermiquement conductrice 500 est, par exemple, supérieure à 2 W/m.K, de préférence supérieure à 3 W/m.K voire encore plus préférentiellement supérieure à 5 W/m.K. Elle peut aller, par exemple, jusqu'à 7 W/m.K.

L'utilisation d'une résine thermiquement conductrice 500, de type MUF, permet d'améliorer la dissipation de chaleur d'un facteur 3 par rapport à l'utilisation d'un TIM.

Comme le capot est assemblé sur le composé de moulage 400 ou sur le substrat 200, la résine thermiquement conductrice 500 est en contact avec toute la deuxième face 102 de la puce 100, ce qui améliore d'autant plus la dissipation de la chaleur de la puce 100 vers l'extérieur.

La colle 450 ou les joints de brasage 460 jouent le rôle de cale et permettent de positionner correctement le capot 300 à la hauteur désirée par rapport à la puce 100.

Avec un tel procédé, l'uniformité (épaisseur et surface couverte) de la couche de résine 500 entre le capot 300 et la puce 100 est contrôlée. L'épaisseur de la ligne de liaison (BLT pour 'Bond Line Thickness') est facilement contrôlée en ajustant l'épaisseur de colle. Elle est typiquement comprise entre 50 et 100 µm.

Le dispositif électronique obtenu présente une très bonne dissipation thermique.

Le capot 300, le composé de moulage 400, la résine thermiquement conductrice 500 et le substrat d'interconnexion 200 forment le boîtier de la puce 100. Le dispositif présente ainsi une bonne tenue mécanique et les problèmes de délamination sont évités. La durée de vie ainsi que les performances du composant sont améliorées.

Nous allons maintenant décrire plus en détail les différentes étapes de ce procédé et les différents éléments utilisés pour obtenir le dispositif électronique.

L'ensemble fourni à l'étape a) comprend une puce 100 assemblée sur un substrat d'interconnexion 300 au moyen de plots de contact 110.

La puce 100 comprend une première face principale 101 (face inférieure) et une deuxième face principale 102 (face supérieure). Elle comprend également des faces latérales reliant les faces principales entre elles.

La puce 100 peut comprendre un substrat, dans et/ou sur lequel sont formés des circuits intégrés et/ou des éléments électroniques discrets, comme des transistors, et un empilement d'interconnexion formé de couches isolantes et conductrices situé du côté de la première face 101 de la puce 100. Par exemple, le substrat est un substrat semiconducteur, notamment en silicium. Ces différents éléments/différentes parties ne sont pas représentées sur les figures pour une meilleure lisibilité.

La puce 100 est une puce dite retournée ('flip-chip'), c'est-à-dire que la partie active de la puce 100 est disposée en regard du substrat d'interconnexion 200.

La première face principale 101 est recouverte par des plages de connexion 120. La connexion entre la puce 100 et le substrat d'interconnexion 200 s'effectue par l'intermédiaire de ces plages de connexion 120. La puce 100 peut comprendre plusieurs plages de connexion 120. La puce 100 peut comprendre au moins une dizaine de plages de connexion 120, par exemple, au moins une centaine de plages de connexion 120. A titre d'exemple, les plages de connexion 120 sont régulièrement réparties sur la face inférieure 101 de la puce 100. Elles peuvent être agencées en réseau matriciel.

Les plages de connexion 120 sont en un matériau conducteur électriquement. Par exemple, les plages de connexion 120 sont en un matériau brasable. Les plages de connexion 120 sont, par exemple, en cuivre, en argent ou en étain, ou en un alliage, par exemple à base d'étain et d'argent (SnAg).

Les plages de connexion 120 sont électriquement connectées au substrat d'interconnexion par des plots de connexion 110. Les plots de connexion 110 sont, par exemple, en un matériau brasable.

Le substrat d'interconnexion 200 permet d'assembler la puce 100 à un dispositif extérieur selon une technique dite de montage en surface.

Le substrat d'interconnexion 200 peut avoir, en vue de dessus, une forme sensiblement carrée ou rectangulaire. A titre d'exemple, le substrat 200 est, en vue de dessus, plus grand que la puce 100. Le substrat 200 peut avoir des dimensions en vue de dessus, supérieures à 10 mm par 10 mm et inférieures à 110 mm par 110 mm, par exemple de l'ordre de 25 mm par 25 mm.

Le substrat 200 comprend, par exemple, un empilement 220 de différentes couches isolantes et de différentes couches métalliques pour former des interconnexions entre les deux faces principales du substrat 200. Le substrat 200 peut comprendre des vias métalliques 230 verticaux dans l'orientation des figures.

Sur les différentes figures et dans les différents modes de réalisation, une seule puce 100 est représentée. Cependant, il est possible d'avoir plusieurs puces.

Des dispositifs électroniques passifs supplémentaires non représentés, tels que, par exemple, des résistances, des inductances et des condensateurs, peuvent être montés sur le substrat 200 autour de la puce 100.

Une couche de polymère 130 électriquement isolant ('underfill') est positionnée, sous la puce 100, entre le substrat d'interconnexion 200 et la première face 101 de la puce 100. La couche de polymère 120 enrobe les plots de connexion 110 de la puce. Cette couche 130 permet de protéger l'intégrité mécanique des plots 110 et les protège de l'oxydation. Cette couche 130 d'enrobage est, par exemple, une couche en époxy. Elle est injectée après le report de la puce 100 sur le substrat 200 par capillarité.

La puce 100 est partiellement enrobée dans un composé de moulage 400 laissant accessible sa deuxième face 102. Les faces latérales de la puce 100 sont recouvertes par le composé de moulage époxy. Le composé de moulage 400 recouvre le substrat d'interconnexion 200 et la partie de la couche de polymère 130 électriquement isolant pouvant dépasser de la puce 100.

Le composé de moulage 400 peut être formé par moulage assisté par film ('film-assisted molding').

Le composé de moulage 400 est, de préférence, un composé de moulage époxy (ou EMC pour 'Epoxy Molding Compounds'). Le composé de moulage 400 comprend une matrice polymère, de préférence époxy, dans laquelle sont dispersées des charges, notamment des charges inorganiques. Les charges inorganiques sont par exemple des charges de silice. Le composé de moulage 400 peut également comprendre des additifs pour améliorer ses propriétés mécaniques et/ou thermiques. Lors de l'étape a), le matériau est polymérisé et rigide et permet d'améliorer la tenue mécanique des éléments avec lesquels il est en contact.

De préférence, le composé de moulage époxy 400 est un matériau présentant une bonne conductivité thermique afin de permettre également l'évacuation de la chaleur par les flancs de la puce. Il peut être en un même matériau que la résine thermiquement conductrice 500 ou en un matériau différent.

Le composé de moulage 400 présente une première face 401 en contact avec le substrat d'interconnexion et une deuxième face 402 qui va être, par la suite, recouverte par le capot 300 et la résine thermiquement conductrice 500.

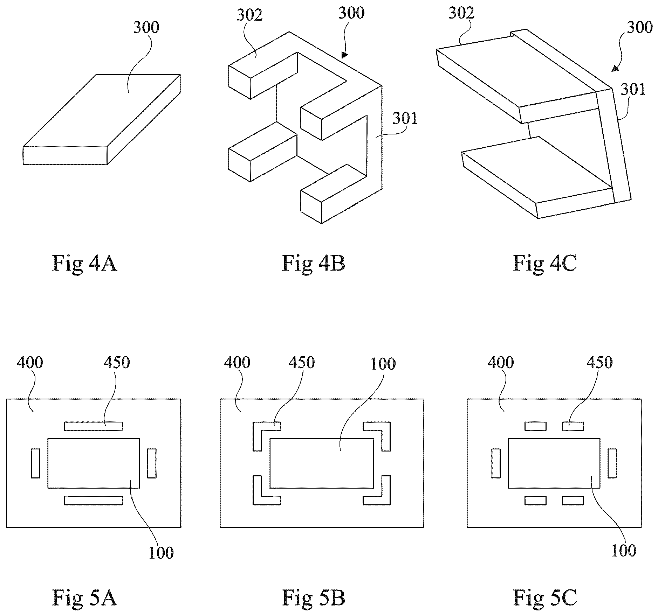

Lors de l'étape b), le capot 300 est assemblé à l'ensemble fourni à l'étape a). Selon un mode de réalisation particulier, le capot 300 peut être plan (comme par exemple représenté sur la figure 4A). Il peut s'agir d'une plaque par exemple. Le capot 300 est collé sur le composé de moulage 400 au moyen d'une colle 450 (comme par exemple représenté sur la figure 1B). La colle 450 peut être déposée sous forme de points de colle, d'un cordon de colle discontinu, de serpentins, sous forme de 'X' ou sous tout autre forme adaptée. Différents motifs de colle 450 sont par exemple représentés sur les figures 5A à 5C. La forme du motif de colle 450 et son épaisseur sont choisies, par exemple, en fonction de la taille de la puce 100 afin d'assurer une bonne fixation du capot 300 sur le composé de moulage 400 et de laisser suffisamment d'espace pour que la résine 500 puisse être injectée sous le capot 300. L'épaisseur des plots, cordons ou serpentins de colle 450 est, par exemple, comprise entre 50 et 100 µm.

Selon un autre mode de réalisation particulier, le capot 300 présente une partie supérieure plane 301 destinée à recouvrir la puce 100 et au moins deux éléments inférieurs 302 solidaires de la partie supérieure 301 servant à fixer le capot 300 sur le composé de moulage 400 ou sur le substrat 200. Les éléments inférieurs 302 sont, de préférence, perpendiculaires à la partie supérieure 301. Ils forment, par exemple, des pieds du capot (figure 4B) ou des éléments de soutien plats (figure 4C). Les éléments de soutien plats sont par exemple des plaques.

Selon ce mode de réalisation, préalablement à l'étape b), des cavités, encoches ou tranchées peuvent être formées dans le composé de moulage 400. Par la suite on décrira des cavités mais tout autre évidement non traversant ou traversant (selon le mode de réalisation) peut être envisagé. Les cavités 410 peuvent être réalisées avec un laser.

Les dimensions des cavités 410 seront choisies en fonction des dimensions du capot 300. Les éléments inférieurs 302 du capot peuvent être :
- collés au fond des cavités 410 sur le composé de moulage 400 lorsque les cavités ne traversent pas l'épaisseur du composé de moulage 400 (comme par exemple représenté sur la figure 2B),
- collés ou brasés au fond des cavités 410, directement, sur le substrat d'interconnexion 200, au moyen de points de colle 450 ou de joints de brasage 460 lorsque les cavités 410 traversent l'épaisseur du composé de moulage 400 (comme par exemple représenté sur la figure 3B) ; pour un brasage, le substrat d'interconnexion 200 sera configuré pour permettre le brasage (par exemple, il comportera localement à sa surface au moins un plot métallique ou sera localement gravé pour rendre accessible au moins une couche métallique présente dans le volume de l'empilement 220).

Selon ces différents modes de réalisation, la forme du capot 300 et le positionnement de la colle 450/des joints de brasage 460 sont choisis de manière à ce que, à l'issue de l'étape b), le capot 300 recouvre la puce 100, et qu'il soit possible d'injecter le MUF 500 lors de l'étape c), la résine 500 dans l'espace formé entre la deuxième face 102 de la puce 100 et le capot 300.

Selon ces différentes variantes de réalisation, la colle 450 peut être disposée sur le capot 300 et/ou sur le composé de moulage 400 (ou sur le substrat 200).

Une étape de polymérisation peut être réalisée suite au dépôt de la colle 450.

La colle 450 est choisie de manière à assurer une bonne tenue mécanique du capot 300 sur l'ensemble fourni à l'étape a). La colle 450 est, par exemple, une colle époxy.

Selon ces différentes variantes de réalisation, la colle 450 ne recouvre pas la puce 100. Dans le cas d'un capot plan 300, on choisira, par exemple, de positionner la colle 450 à une distance d'au moins 500µm du bord de la deuxième face 102 de la puce 100.

Le capot 300 est thermiquement conducteur. Le capot 300 est, par exemple, un capot métallique, par exemple, en cuivre ou en acier inoxydable et est, éventuellement, plaqué d'une couche de nickel. La partie du capot 300 recouvrant la puce 100 a une épaisseur comprise entre 300 et 1000 µm, de préférence entre 500 et 1000 µm.

Lors de l'étape c), on injecte la résine thermiquement conductrice 500 pour former une couche de dissipation thermique entre la puce 100 et le capot 300. La couche de résine 500 permet de dissiper la chaleur produite par la puce 100 lors de son fonctionnement vers le capot métallique 300 puis vers l'extérieur du dispositif 1000.

La résine 500 est injectée par moulage. Ce type de matériau peut s'infiltrer entre le capot 300 et le composé de moulage 400 pour remplir l'espace entre le capot 300 et la deuxième face 102 de la puce 100. De préférence, il recouvre également les flancs du capot 300.

L'étape c) est réalisée de manière à laisser accessible la face arrière du capot 300. La résine 500 peut être déposée par injection par moulage assisté par film ('film-assisted molding').

L'étape c) peut être réalisée avec les équipements classiquement utilisés dans l'industrie microélectronique.

Après injection de la résine 500, une étape de polymérisation (durcissement) est mise en œuvre. Elle peut être réalisée par traitement thermique, par exemple, à une température 175°C pendant 3h.

La résine 500 durcie assure une liaison thermique permanente et fiable entre le capot 300 et la puce 100.

La résine 500 acquiert ainsi une certaine rigidité et une certaine adhésion. Elle est ainsi non seulement solidaire du capot 300 et de la puce 100 mais également rigide. Elle peut favoriser le maintien mécanique du dispositif final.

La résine 500 est, par exemple, commercialisé par la société Sumitomo Bakelite Co., Ltd.

A l'issue du procédé, on obtient un composant électronique pouvant être assemblé à un élément extérieur.

Le composant électronique comprend une puce 100 ayant une première face 101 et une deuxième face 102, des plages de connexion 120 positionnées sur la première face 101 de la puce 100 étant assemblée sur un substrat 200 par des plots de connexion 110.

Un capot 300 en un matériau thermiquement conducteur recouvre la puce 100. Il peut être fixé soit au composé de moulage 400 par collage soit au substrat 200 par collage 400 ou par soudage/brasage. Le capot 300 est moulé dans une couche de résine thermiquement conductrice 500. La résine thermiquement conductrice 500 remplit l'espace entre le capot 300 et la deuxième face 102 de la puce 100 et se prolonge jusqu'à recouvrir également les flancs du capot 300. Seule la face arrière du capot n'est pas recouverte par la résine 500.

Le capot 300, le composé de moulage 400, la résine thermiquement conductrice 500 et le substrat d'interconnexion 200 forment un boîtier protégeant la puce 100 et permettant de la relier électriquement à un élément extérieur (non représenté sur les figures), par exemple un dispositif extérieur ou à un substrat de type PCB (carte de circuit imprimé ou 'printed circuit board'). Le substrat 200 peut être monté et connecté électriquement sur le dispositif extérieur, par exemple au moyen de plots d'interconnexion 250 positionnées sur la deuxième face du substrat 200.

Les plots d'interconnexion 250 peuvent être des billes, piliers ou des colonnes. Les billes 250 sont par exemple régulièrement réparties sur la face inférieure du substrat 200, par exemple selon un réseau matriciel. Les dimensions latérales des billes 250 et le pas inter-billes 250 sont par exemple supérieurs respectivement aux dimensions latérales des plots de contact 110 de la puce et au pas inter-plots 110 de la puce 100. Le substrat 200 réalise ainsi une fonction d'étalement et de redistribution des contacts de la puce 100 vers les contacts du dispositif extérieur.

De tels composants électroniques, aussi appelés composant TEFCBGA (pour 'thermally enhanced flip chip -ball grid array') sont particulièrement intéressants pour de nombreuses applications.

Ils permettent de réaliser un grand nombre d'I/O, avec des bonnes performances et une bonne dissipation thermique.

Le dispositif est, par exemple, destiné à l'industrie automobile. En particulier, le dispositif peut être utilisé dans un microcontrôleur ou dans un système avancé d'aide à la conduite (ADAS pour 'Advanced Driver Assistance Systems').

Il peut être utilisé dans les dispositifs de calcul intensif (HPC pour 'High-performance computing'), par exemple dans les unités centrales de traitement (CPU pour 'Central Processing Unit') ou dans les processeurs graphiques (GPU pour 'Graphics processing unit').

Le dispositif peut par exemple être utilisé dans le domaine industriel. Plus particulièrement, le dispositif vise par exemple à être utilisé pour le développement des énergies vertes ou pour l'électrification d'infrastructures, par exemple pour des bornes de recharge ou pour l'énergie solaire.

Le dispositif peut également être utilisé dans le domaine de l'internet des objets et des maisons intelligentes.

Le dispositif peut également être utilisé dans la mise en œuvre de réseaux 5G, de centres de données et de serveurs.

Le dispositif est, par exemple, destiné à être utilisé dans de l'électronique personnelle, par exemple dans le but d'augmenter le contenu radiofréquence, dans les dispositifs de connexions 5G ou plus généralement dans les dispositifs connectés. Le dispositif est, par exemple, utilisé dans des téléphones portables ('smartphone') ou pour les réseaux de l'internet des objets. Le dispositif est par exemple connecté par 5G ou WIFI. L'appareil comprend par exemple des interfaces à haut débit, par exemple avec un filtrage avancé et une protection contre les décharges électromagnétiques.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Procédé de fabrication d'un dispositif électronique comprenant les étapes suivantes :
a) fournir un ensemble comprenant une puce (100) et un substrat d'interconnexion (200), la puce ayant une première face (101) recouverte par des plages de connexion (120) et une deuxième face (102), les plages de connexion (120) étant assemblée sur le substrat d'interconnexion (200) par des plots de contact (110), la puce (100) étant moulée dans un composé de moulage (400), par exemple un composé de moulage époxy, laissant accessible la deuxième face (102) de la puce (100),
b) assembler un capot (300) sur l'ensemble fourni à l'étape a), un espace étant formé entre le capot (300) et la deuxième face (102) de la puce (100),
c) injecter une résine thermiquement conductrice (500) de manière à remplir l'espace entre le capot (300) et la deuxième face (102) de la puce (100), la résine thermiquement conductrice (500) étant une résine dans laquelle sont dispersées des charges thermiquement conductrices.

2. Procédé selon la revendication 1, dans lequel la résine thermiquement conductrice (500) est une résine époxy dans laquelle sont dispersées des charges thermiquement conductrices, par exemple des charges en silice.

3. Procédé selon l'une des revendications précédentes, dans lequel la résine thermiquement conductrice (500) et le composé de moulage (400) sont en un même matériau.

4. Procédé selon l'une des revendications 1 à 3, dans lequel le capot (300) est une plaque et dans lequel le capot (300) est collé sur le composé de moulage (400), au moyen de points de colle (450) ou d'un cordon discontinu de colle (450) .

5. Procédé selon l'une des revendications 1 à 3, dans lequel le capot (300) comprend une partie plane (301) et des éléments (302) faisant saillie à partir de la partie plane (301), les éléments (302) faisant saillie étant fixés au fond de cavités (410) formées dans le composé de moulage (400).

6. Procédé selon la revendication 5, dans lequel les cavités (410) ont une profondeur inférieure à une épaisseur du composé de moulage (400) et dans lequel les éléments (302) faisant saillie sont collés sur le composé de moulage (400) formant le fond des cavités (410).

7. Procédé selon la revendication 5, dans lequel les cavités (410) débouchent sur le substrat d'interconnexion (200) et dans lequel les éléments (302) faisant saillie sont collés ou brasés sur le substrat d'interconnexion (200).

8. Procédé selon l'une des revendications 5 à 7, dans lequel les éléments (302) faisant saillie forment des pieds, par exemple quatre pieds, ou des plaques.

9. Procédé selon l'une des revendications précédentes, dans lequel l'étape c) est réalisée par moulage assisté par film.

10. Dispositif électronique comprenant une puce électronique (100) disposée entre un substrat d'interconnexion (200) et un capot (300), la puce ayant une première face (101) recouverte par des plages de connexion (120) et une deuxième face (102), les plages de connexion (120) étant assemblée sur le substrat d'interconnexion (200) par des plots de contact (110),
la puce (100) étant moulée dans un composé de moulage (400), par exemple un composé de moulage époxy, laissant accessible la deuxième face (102) de la puce (100),
le capot (300), de préférence en cuivre, recouvrant la deuxième face (102) de la puce (100),
une résine thermiquement conductrice (500) remplissant un espace entre le capot (300) et la deuxième face (102) de la puce (100) et, de préférence recouvrant des flancs du capot (300), la résine thermiquement conductrice (500) étant une résine dans laquelle sont dispersées des charges thermiquement conductrices..

11. Dispositif selon la revendication 10, dans lequel la résine thermiquement conductrice (500) est une résine époxy dans laquelle sont dispersées des charges thermiquement conductrices.

12. Dispositif selon l'une des revendications 10 à 11, dans lequel la résine thermiquement conductrice (500) est identique au composé de moulage.

13. Dispositif selon l'une des revendications 10 à 12, dans lequel le capot (300) est une plaque et dans lequel le capot (300) est collé sur le composé de moulage (400), au moyen de points de colle (450) ou d'un cordon discontinu de colle (450).

14. Dispositif selon l'une des revendications 10 à 12, dans lequel le capot (300) comprend une partie plane (301) et des éléments (302) faisant saillie à partir de la partie plane (301), les éléments (301) faisant saillie étant fixés au fond de cavités (410) formées dans le composé de moulage (400).
